# EUROPEAN PATENT SPECIFICATION

(11) **EP 0 337 720 B1**
(45) Date of publication and mention of the grant of the patent: **19.08.1998**
(21) Application number: 89303550.1
(22) Date of filing: 11.04.1989
(51) Int. Cl.: H01L 29/732, H01L 21/331, H01L 21/8222, H01L 21/285

(54) **Method for fabricating a bipolar transistor**
Verfahren zur Herstellung eines Bipolartransistors
Méthode de fabrication d'un transistor bipolaire

(30) Priority: 11.04.1988 US 180626
(43) Date of publication of application: 18.10.1989
(73) Proprietor: SYNERGY SEMICONDUCTOR CORPORATION, Santa Clara California 95051 (US)
(72) Inventor: Pollock, Larry Joseph, Palo Alto, CA 94301 (US); Brown, George William, San Jose CA 95132 (US)
(74) Representative: Cross, Rupert Edward Blount

(56) References cited:
- EP-A- 192 871
- EP-A- 193 934
- EP-A- 200 603
- EP-A- 253 538
- GB-A- 2 183 093
- IBM TECHNICAL DISCLOSURE BULLETIN vol. 19, no. 2, July 1976, pages 569,570, New York, US; D.J. FLEMING et al.: "Open-Collector Structure Lateral PNP Transistor"

## Description

### CROSS-REFERENCE TO RELATED APPLICATION

The process disclosed in this application is especially useful in producing structures of the type disclosed in US-A-5 029 129 (& EP-A-0 324 580, published 19/07/89), assigned to the assignee of this invention and incorporated herein by reference.

### FIELD OF THE INVENTION

This invention relates to a method for fabricating high-performance bipolar integrated circuits, the resulting circuits occupying a minimum horizontal area and with minimum junction depth.

### BACKGROUND OF THE INVENTION

The present trend in semiconductor technology is toward large scale integration of devices with very high speed and low power performance. The parameters that are essential to such high performance bipolar transistors include the presence of low parasitic capacitances as realized by shallow vertical junctions, and small horizontal geometries. In other words, it is necessary to make the devices in the integrated circuits as small as possible in both the horizontal and vertical directions.

With advances in semiconductor processing technology such as in the fields of ion implantation, dielectric isolation, electron beam and X-ray lithography, fabrication of ultra high performance integrated circuit devices can be achieved. In other process technologies, fabrication of high performance integrated circuit devices has been improved.

EP-A-0193934 describes a method of fabricating a vertical NPN bipolar transistor in which an impurity layer formed of a laminated layer of a polysilicon layer and a metal silicide layer serves as a diffusion source for forming an emitter region in the base region which enables a shallow junction to be obtained improving the high speed operating characteristics. The method includes forming a buried oxide isolation region, extending through the epitaxial layer to the buried layer and which separates the collector contact region from the extrinsic base region.

One approach developed to reduce the size of integrated circuits has been the use of trench or slot isolation to isolate adjacent bipolar structures. Because this technique incorporates etching grooves into the semiconductor wafers adjacent to those regions in which PN junctions are to be formed, it becomes increasingly important to make the device as shallow as possible in order to minimize the depth to which the groove must be etched.

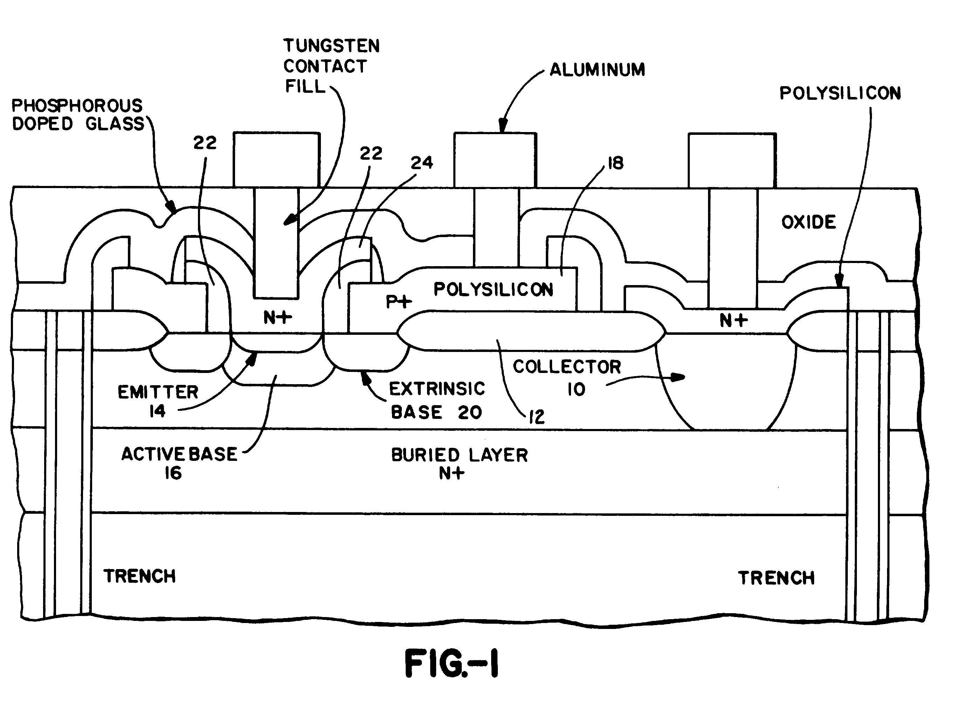

The Texas Instruments process illustrated in FIG 1 is typical of advanced bipolar processes as presently executed. As can be seen, it includes an outboard collector 10 which is isolated by field oxide 12 from the remainder of the device, thereby extending the horizontal region of the integrated circuit occupied by each NPN transistor. Similar efforts have been made by IBM as disclosed in US Patents 4,392,149 4,319,932 and 4,338,138. All of these patents are characterised by a resulting structure including a remote collector. They are also characterized by a relatively deep structure to incorporate the buried layer, which is necessary to get a low sheet resistance in the buried layer. This deep buried layer results in the need for providing a trench or slot or a deep isolation with the oxide isolation negative results discussed above.

Use of a separate collector also requires providing a separate island in the oxide to make connection to this collector. Use of a remote collector also requires provision of a relatively thick buried layer to provide the desired low resistance between emitter and collector. It should be noted that in prior art structures, to achieve a low sheet resistivity for the buried layer requires that the buried layer be about 3 µm (microns) thick. Formation of the buried layer further requires considerable heat cycling and heavy doping, all of which introduces stresses into the finished structure, and results in a relatively deep structure. Additionally, putting down the P-poly first requires that the area which is to become the active emitter be subjected to the etch processing required to open this P-poly for the N-poly emitter which comes later. This potentially subjects the single crystal silicon in the active emitter to etch damage which can induce emitter defects. Another difficulty that follows from the use of processes of the type appearing in FIG 1 is that in order to obtain minimum a geometry structure, the emitter 14 is self-aligned with the active base 16. However, this requires that the P-poly layer 18 has to make contact to the active base 16 by diffusing the extrinsic base regions 20 under the oxide spacers 22 which separate the N-poly layer 24 and the P-poly layer 18. This requires significant heat treatment of the extrinsic base regions 20 and the intrinsic base regions and this extra heat treatment makes the intrinsic base regions 16 relatively deep. The provision of deep extrinsic base regions reduces the ability to obtain shallow junctions which is one of the objectives of this process design. Further, if the collector 10 were moved to be more closely adjacent to the base region, very high collector base capacitance, and relatively low breakdown voltages would result. Therefore, the processes disclosed in the prior art are relatively difficult to control in terms of achieving the process objectives of optimizing shallow junctions, minimum device area, low defects and low parasitic capacitances, with the highest performance possible.

It is an object of this invention to provide an improved method of making a small geometry bipolar transistor within a given masking or lithographic capability.

Another objective herein is to provide a method of making a bipolar transistor that will exhibit reduced collector base junction capacitance.

Another objective is to provide a method for producing a bipolar transistor that will have greatly reduced collector-substrate junction capacitance.

Another objective is to provide a method for producing a bipolar transistor that have greatly reduced parasitic collector resistance.

Yet another objective is to provide a method for fabricating a bipolar transistor that is simple and precise, provides good yield, and results in a shallow transistor with improved characteristics that are easier to process.

An objective of an embodiment of this invention is to provide a method for producing a bipolar transistor that will have both an implanted base and shallow junctions in order to minimize parasitic capacitance.

A further objective is to protect the active emitter area from harsh etches during processing and thus reduce defects in this sensitive area.

A further objective is to provide a method for producing a bipolar transistor that works well with the formation of CMOS devices in a BICMOS process.

According to the present invention, there is provided a method for fabricating a bipolar transistor without a field oxide layer within the epitaxial layer separating the collector contact and base region comprising the following successive steps:(a) forming on a semiconductor substrate of P-type material a layer of N-type material, over which layer is formed an epitaxial layer of N-type material, whereby said layer is buried; (b) forming an isolation trench and an adjoining, N-type sinker region in the structure resulting from step (a), in which the isolation trench extends through the epitaxial layer, the buried layer, and into said substrate, and the sinker region provides a low resistance current path from an upper surface of said epitaxial layer to said buried layer, the region bounded by said trench defining an isolated region in which the bipolar transistor is to be fabricated; c) forming an oxide layer edging the walls of said trench formed in step (b) ; (d) filling said trench with polysilicon; (e) forming a field oxide layer over said trench; (f) forming a P-type active base region in said epitaxial layer within said isolated region; (g) forming an emitter contact, and a collector contact on the structure resulting from step (f), comprising the steps of: (i) forming on the entire epitaxial layer a layer of polysilicon doped with N-type dopant, and forming a protective oxide layer over said polysilicon layer; (ii) patterning said N-type polysilicon layer and said oxide layer, said patterning defining an emitter region within said active base region and an emitter contact, said emitter contact overlying at least a portion of said active base region, and defining a separate collector contact outside said active base region, on said epitaxial layer, overlying at least a portion of said sinker region, said patterning forming vertical sidewalls in said doped polysilicon layer and said oxide layer; (h) depositing an oxide layer over the structure resulting from step (g) and performing an anisotropic etch on this oxide layer, thereby forming oxide sidewall spacers on said isolated region, adjoining said vertical sidewalls in said doped polysilicon layer whereby a portion of said isolated region is left exposed; (i) heating the structure resulting from step (h) thereby forming an emitter region and a collector contact region by diffusion of said N-type dopant from said polysilicon into said epitaxial layer thereby forming an emitter region having a depth, and thereby forming a collector contact region; (j) depositing a further layer of polysilicon doped with P-type dopant over said oxide layer and in contact with said exposed portion of said isolated region; (k) heating the structure resulting from step (j) to diffuse said P-type dopant from said further layer of polysilicon into said portion of said isolated region exposed during anisotropic etching in step (h), thereby forming an extrinsic base region adjacent said active base region; whereby said sidewall spacers have a lateral dimension that defines a lateral separation of said collector contact region and said extrinsic base region of said bipolar transistor and said sidewall spacers and said oxide layer providing electrical insulation between said layer of polysilicon doped with said N-type dopant and said further layer of polysilicon doped with said P-type dopant.

In one embodiment the N-doped polysilicon layer is defined over the active base region and over field oxide regions that are located atop the isolating trenches. This N-poly region, when treated, will provide an interdigitated collector with an emitter region aligned over the active base region to define a minimum geometry device. After appropriate spaced isolation layers are placed, a P-poly layer is laid down and heat treated to cause the P-type doping material to diffuse into the substrate contact to the active base region. The use of an interdigitated collector according to this design on either side of the emitter adjacent to the field oxide will provide a device with reduced up/down resistance between the collector and the buried layer underlying the epi region in which the active base is located. Only a thin epi region is used, and two collector resistances are now effectively created extending to the interdigitated collector, resulting in an effective low collector resistance.

To take advantages of this low collector resistance, the sheet resistance of the buried collector can be raised by making the buried collector shallower. The net result of the combination of a thin epi and collector region is a relatively thin device that can be isolated from adjacent devices by a very shallow slot or trench on the order of about 1/2 to 2/3 of what is needed in prior art devices where lower sheet resistance buried layers are used.

The present structure using a shallow double collector incorporates comparable collector resistance and a shallower buried layer than the prior art. Use of a shallow epi layer in conjunction with a shallower buried collector makes the formation of this epi layer easier to control to a very high degree. Use of this thin epi layer also makes the devices easier to manufacture and less prone to defects. Since the device can be shallower, the isolation depth can be proportionally less, regardless of whether it is fully oxide isolated or trench isolated. The necessity for only a shallow isolation puts less stress on th silicon and takes less process time for formation. Further, the equipment necessary to cut trenches is very expensive, and the time to cut a typical 6 µm (micron) trench is up to two times as long as the approximately 3 to 4 µm (micron) trench of this invention. Another advantage of this device is that an active base is first diffused, after which the collector and emitter are simultaneously defined, a masking tolerance is created between the collector and emitter such that even though they are closely spaced, a very high breakdown voltage is created. Further, very little heat treatment after placement of the field oxide is necessary, and shallow junctions can also be used. Finally, it is relatively easy to incorporate an implanted rather than a diffused base in the process of the present invention, and the steps and sequences of this process works extremely well in the formation of combination bipolar CMOS (BICMOS) devices.

The objects, features and advantages of this invention will be better understood from the following description taken in conjunction with the accompanying drawings.

### BRIEF DESCRIPTION OF THE DRAWINGS

FIG 1 illustrates a prior art process used to create relatively small geometry devices;
FIGs 2A-2G illustrate the sequence used in carrying out the steps in the present invention.
FIG 2H illustrates a finished NPN device as viewed topologically.
FIG 2I illustrates a P-type resistor as is possible in this technology.

### DETAILED DESCRIPTION OF THE DRAWINGS

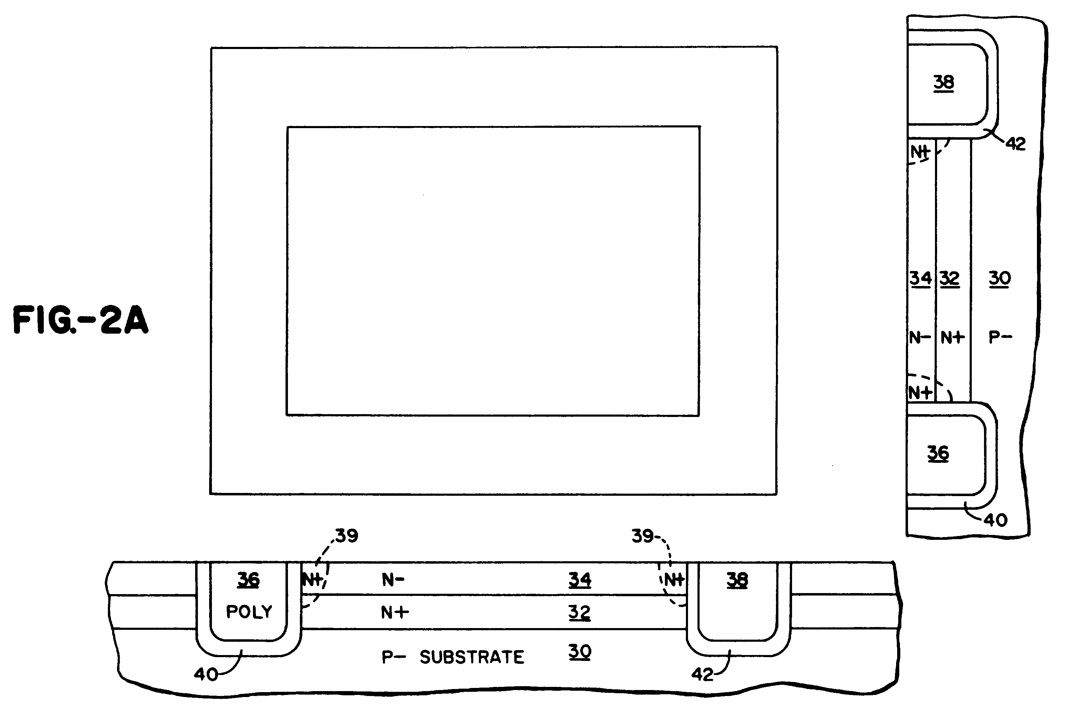

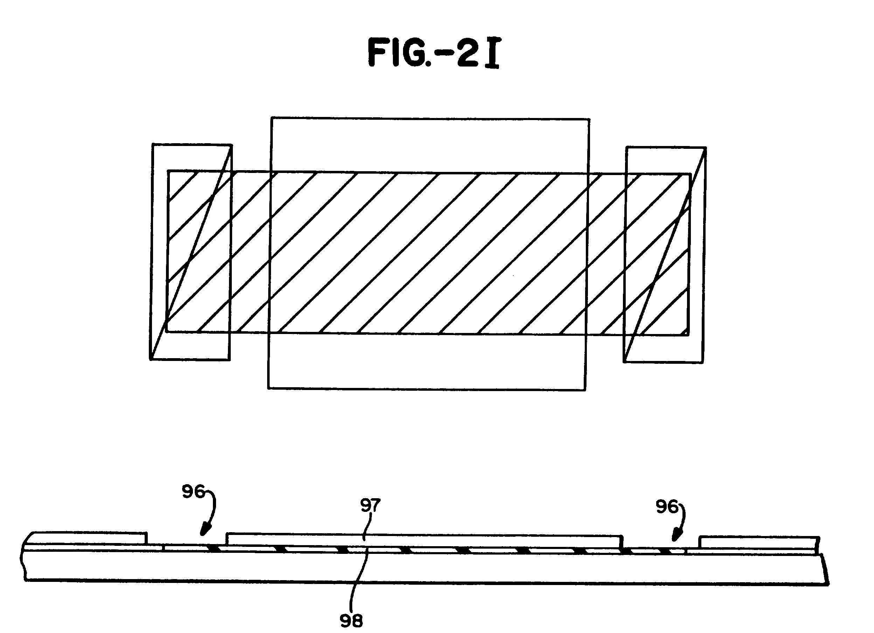

The process described below is suitable for producing high performance bipolar devices wherein all the elements are separated by spacers in order to minimize the size of the device as well as parasitic capacitance in the device. It should be noted that FIGs 2A-2H combine three views of the layout of the device. The center section shows the mask being used to carry out this process. Below that is a vertical cross-section of the structure which is produced as a result of that masking step, and to the right is a vertical cross-section of the same structure taken at a 90° angle to the lower vertical section. Therefore, a complete sectional elevation view of the device is provided by the figures.

The process begins with a P-type substrate 30 as shown in FIG 2A of 7-10 Ω centimeter resistivity. Then an unmasked sheet buried layer 32 of N-type doping material is formed using arsenic or antimony as the dopant. This buried layer 32, according to the present process, need only be about 1 µm (micron) thick. Because of the use of an interdigitated collector structure in the finished product, a very thin and thus very controllable buried layer is defined. This would imply that the process could in fact be started with preprocessed wafers that have this P-substrate 30 and the N-doped buried layer 32 which has a resistivity of about 100 Ω per square.

The next layer, also an unmasked layer, is the epi layer 34 which will be an N-doped layer and approximately 3/4 µm (micron) thick. Up through this process step, the wafer could be stored in batch form because a specific device is not defined until after the buried collector is formed and the epitaxial layer is grown.

After oxidizing the surface of the wafer, the first masking step is carried out to form the trenches 36, 38; these trenches, edged with oxide as shown at 40, 42, and filled with poly as shown at 36, 38, will define the complete, isolated region in which an active NPN transistor will be defined.

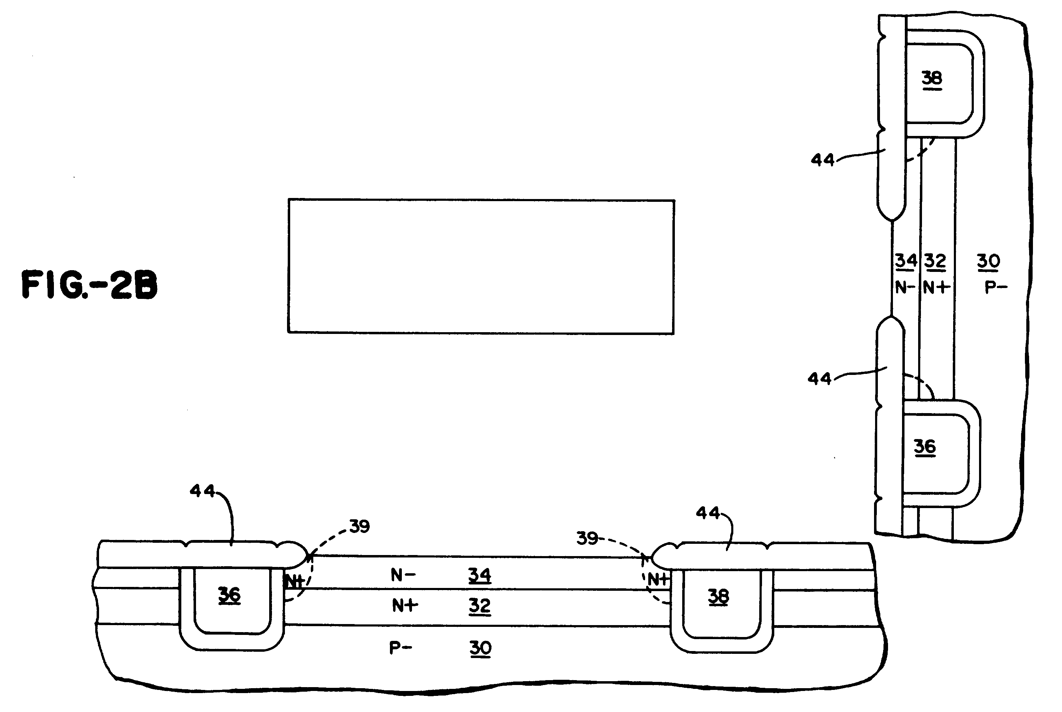

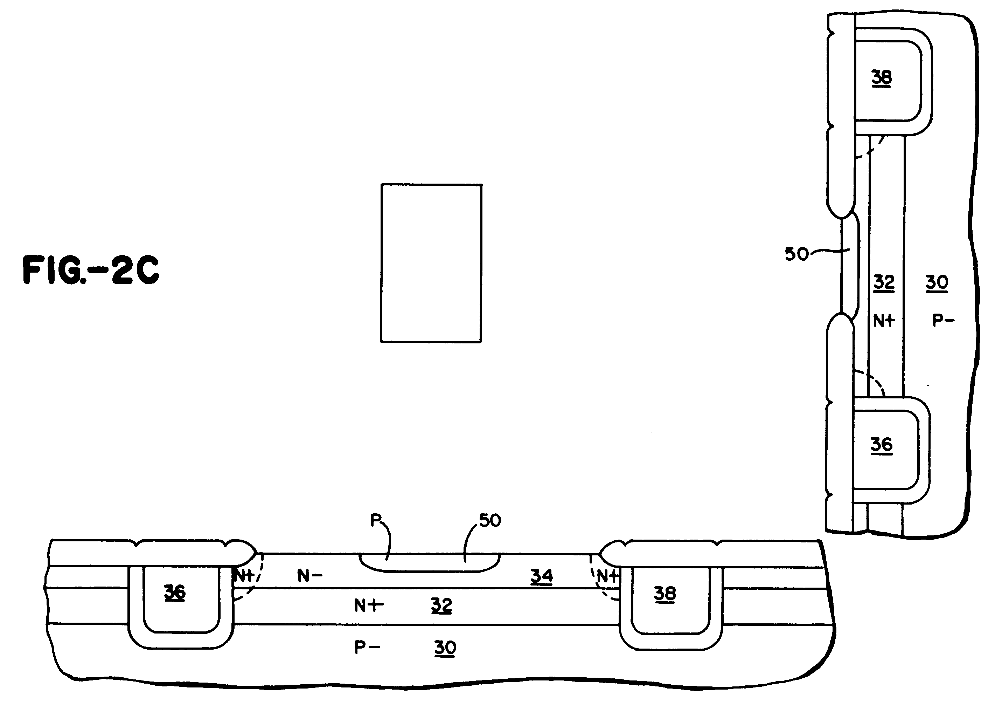

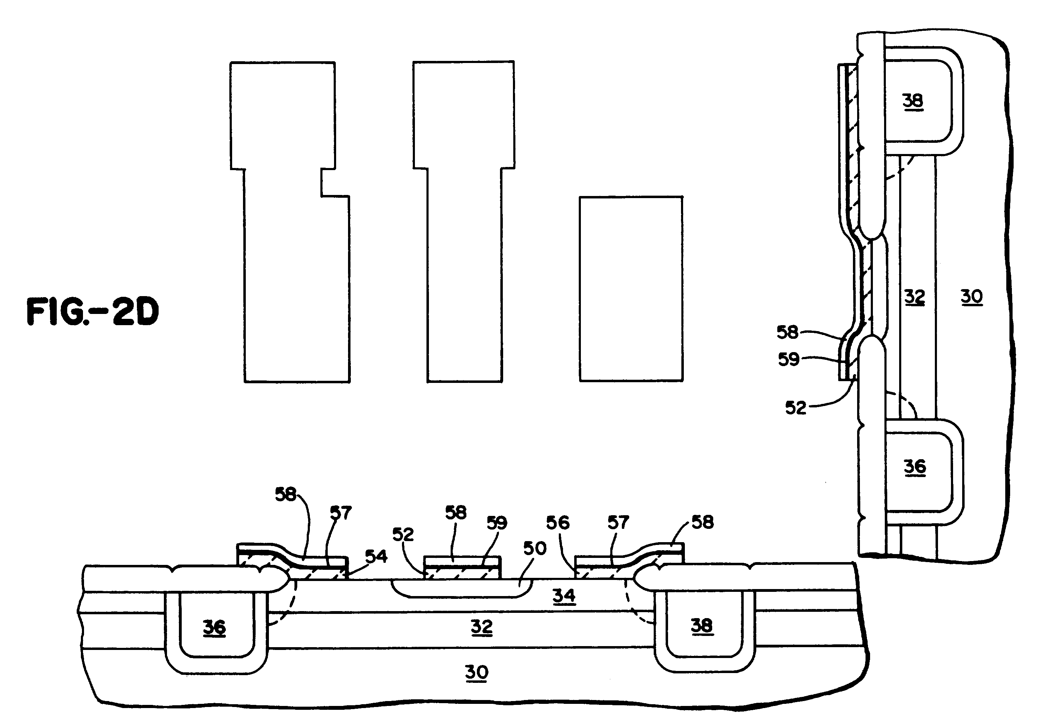

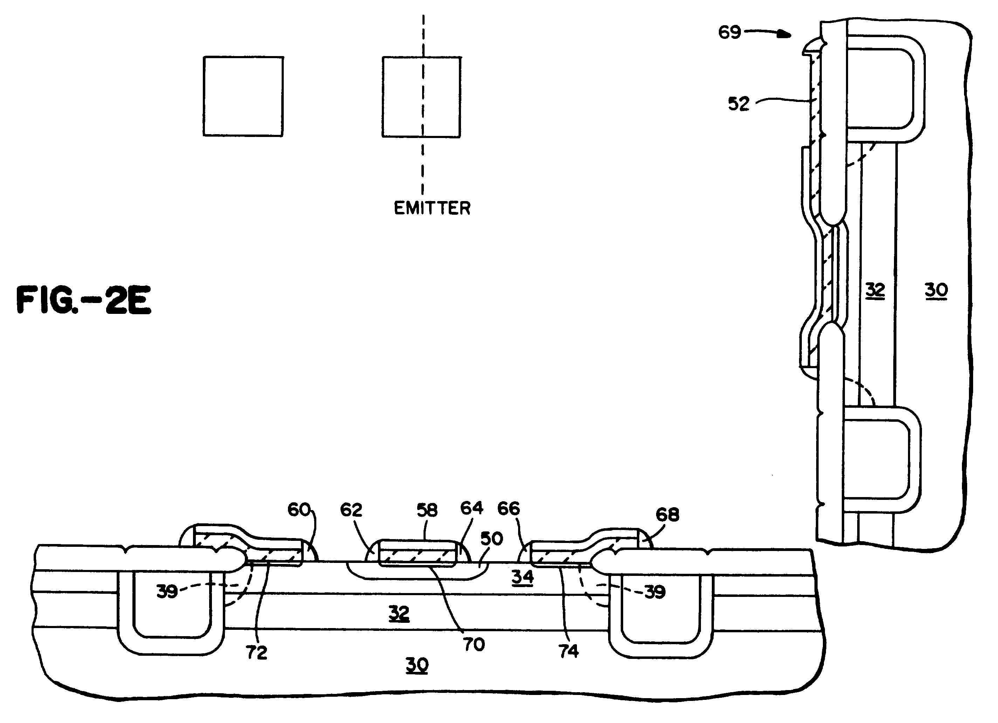

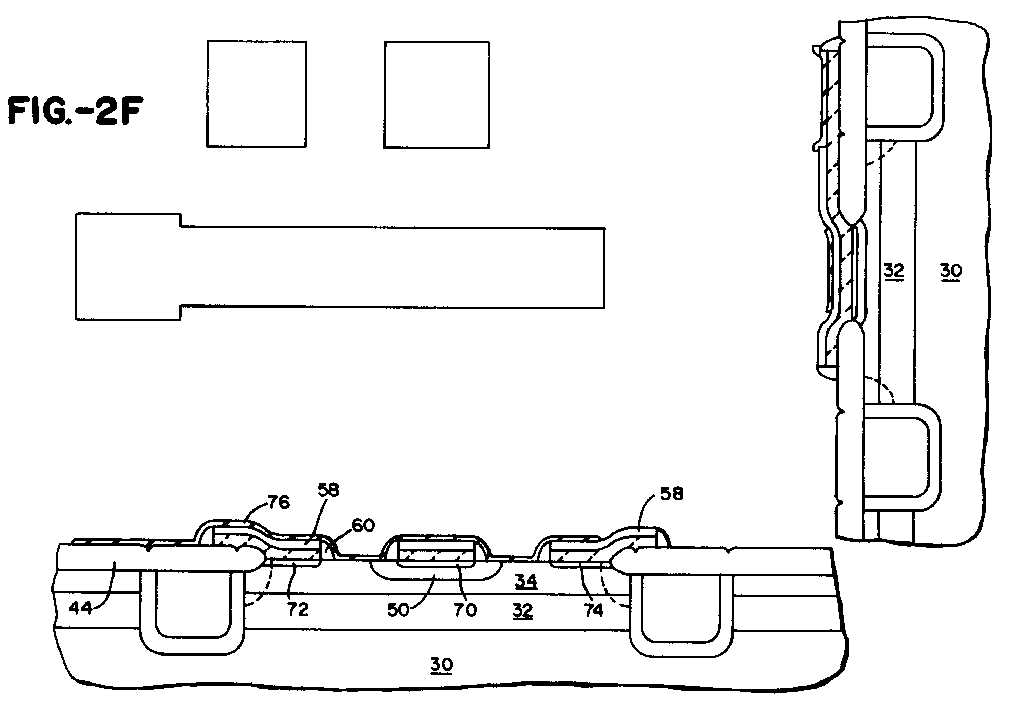

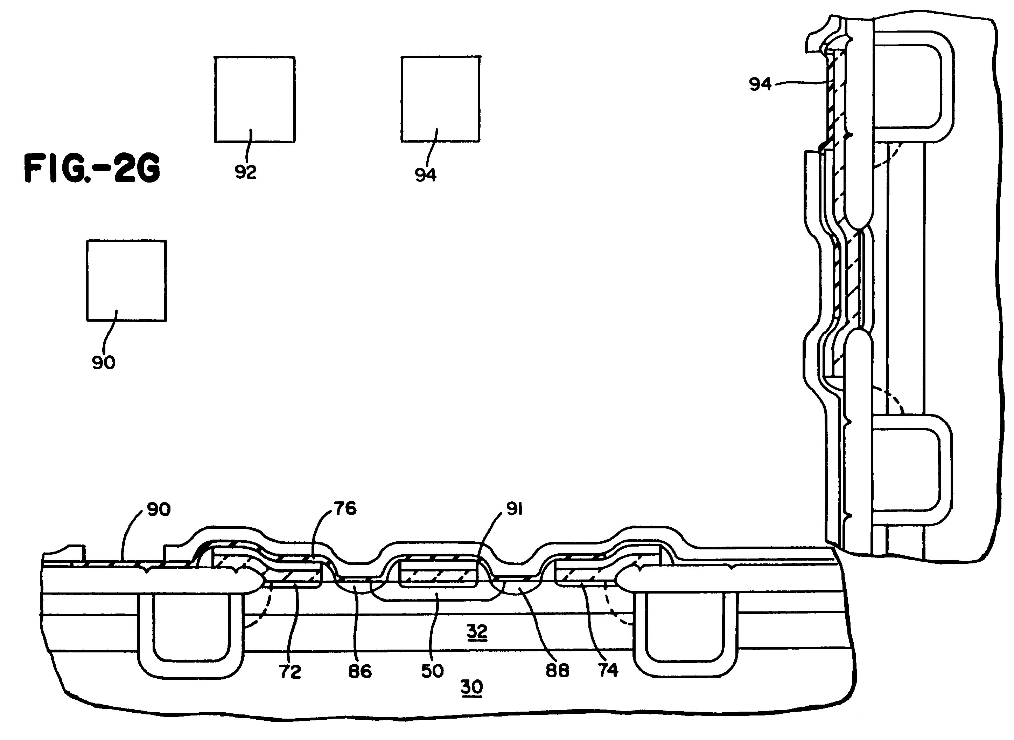

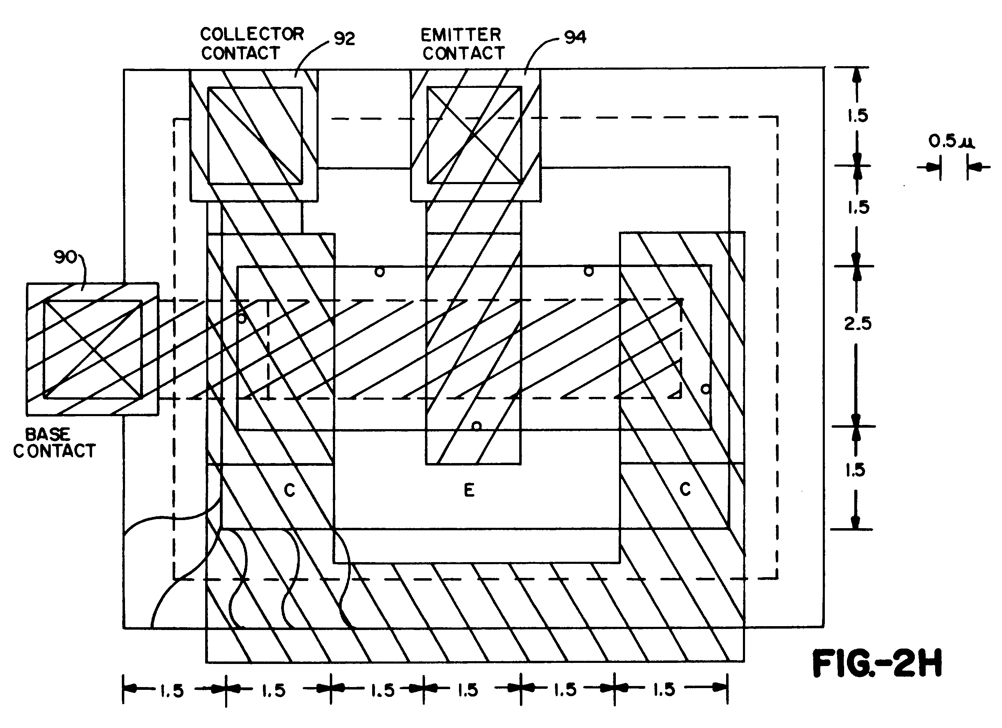

An opaque field mask is used to define the boundaries of a trench that will surround each bipolar transistor on the wafer. A two-step etching process can be used to form the trench 36, 38: the first etch defines a trench down into the buried layer (collector) but not into the substrate; next, an N+ doping along the trench creates an N+ region (sinker) 39, shown by the dashed lines in FIG 2, which will later provide a low resistance current path to the buried layer (collector) 32 from the collector contact which is to be defined in a later step.

The N+ dopant is diffused from the side of the trench 36, 38 into the monocrystalline epitaxy 34 and buried layer 32 beneath the mask; the second etching step involves etching of the trench through the buried collector and into the substrate.

The entire wafer is oxidized, including the sidewalls of the trench 36, 38. The oxide at the bottom of the trench is etched, the entire wafer is covered with a deposition of polysilicon (which also fills in the trench at 40, 42), and the entire surface is then planarized. The formation of the trench and its oxide layer 40, 42 provides complete electrical isolation between adjacent transistors of the circuit and filling the trench with polysilicon helps to smooth the surface of the device by filling the void formed by the trench with polysilicon.

Turning to FIG 2B, the next mask is used to define the extent of the field oxide 44 which will surround the active device and further isolate the device from adjoining devices as well as providing an isolating support layer for some of the connections to be formed. Generally, the field oxide is grown over the trenches to electrically insulate the polysilicon trench fill. The nitride layer, whose extent is defined by the mask, prevents oxidation of the region where the active device is to be located.

The field oxide generally protrudes into the sinker 39, shown by the pointed regions, which are referred to in the industry as "bird beaks." The pointed regions in the field oxide are the result of the presence of the oxide layer along the trench 36, 38 sidewalls between the polycrystalline and monocrystalline silicon areas which does not have excess free silicon to donate to the thermally grown field oxide reaction. The nitride defining the active areas is then removed.

The next step is to define the intrinsic or active base region 50 as shown in FIG 2C. The mask defines an area in the epitaxial layer into which the boron dopant (for a P-type base) will be implanted to form the active base, shown in FIG 2C as the P-region 50. The slope of the sides of the P-region is due to side diffusion of dopant during subsequent heat processing.

The next step, illustrated in FIG 2D, is to simultaneously form the polysilicon emitter and collector contacts 52, 54, 56 aligned with the base 50. In the preferred embodiment, the polysilicon emitter 52 is deposited over the active base 50 and doped with an N-type doping material. In a preferred embodiment, two additional regions 54, 56 of the same N-type poly material are simultaneously formed. These will eventually be used to form the interdigitated collector contact regions of the present transistor device. Specifically, the mask shown in FIG 2D is used to define the area of the active region where the emitter and the double collector are to be formed. A polysilicon layer (Poly I) is first deposited over the entire wafer. The polysilicon is then doped with an N+ dopant. N+ poly can be doped as it is deposited (in situ) implanted or deposited as a deposition after the poly is deposited.

After the emitter and collector 52, 54, 56 are in place, titanium or tungsten is sputtered on, and a thin silicide layer 57, 59 is formed over the collector and emitter. Then an oxide 58 is formed over the entire surface formed to date. The objective is to provide a sandwich of oxide, silicide and poly sitting over the regions to be defined as the emitter and collector regions of the NPN transistor. Using the mask of FIG 2D, the oxide, silicide and Poly I in all but the areas comprising the emitter, collector and their respective contacts are etched away, leaving the Poly I emitter and double collector elements shown in cross hatches of FIG 2D which are covered with silicide and oxide.

The next step is to define the spacers 60, 62, 64, 66, 68 which will separate the emitter and collector diffusions in the present device. The spacers are formed by depositing an oxide layer over the present device and then, as illustrated in FIG 2E, performing an anisotropic etch on this oxide. This removes the oxide down to the epi region and the previously defined oxide 58 of FIG 2D, and leaves the oxide along the vertical side walls of the collector and emitter regions and the separating spacers of the oxide layer 60, 62, 64, 66 and 68.

The spacer shown in the right-hand cross-section of FIG 2E has a step 69. This is the result of forming the spacers before the step of etching to form contact pads as shown in FIG 2E. The present process may be modified to first etch the contact pads in the oxide 58 before forming the spacers or defining the emitter and collector pattern outlined in the steps above. This eliminates the step in the spacer and forms a spacer along the poly edge only and not the poly plus oxide.

Note that the heating used to carry out the oxide growth steps as well as limited additional heat treatment diffuses the emitter region 70 and collector region 72, 74 into the epi layer 34 using the N+ poly region as the source of N+ dopant. It can be seen that the diffused emitter region 70 is included within the active base region 50 and is well separated from the collector region 72, 74 by the epi 34.

FIG 2E also illustrates a method that will be used in the present invention to make contact to the first poly layer 52 specifically by etching through the oxide layer 58 during the anisotropic step described below down to the top of the poly layer 52 so that contact can be made to this poly layer for the purpose of providing an emitter contact. It should be noted from the design of the mask that even though the right hand cross-section shows only the contact to one layer, this step of etching through the oxide to the first poly layer 52 can be used to open a window for a contact both to the emitter 70 and one end of the interdigitated collector 72. Specifically, the contact I mask of FIG 2E defines the regions of the oxide coating over the poly of the emitter and collector contacts that will be etched away to expose the Poly I. As noted in the above paragraph (construction of spacers), the oxide in the contacts defined by the contact I mask of FIG 2D can be removed prior to the Poly I mask and etch step of FIG 2D with the elimination of the oxide step which is shown in the right-hand cross section of FIG 2E. Note in the bottom cross-section of FIG 2E that the base region 50 extends beyond the edges of the active emitter 70 on both sides. Note also a very thin layer underneath each of the emitter 70 and collector 72, 74 that resulted from the N-type dopant in the Poly I diffusing into the epitaxial layer 34. This diffused area actually defines the active collector and emitter contacts and the active emitter region. This diffusion reduces emitter and collector contact resistance and helps to make collector contact with the buried layer (collector) by way of the sinker 39.

The next step shown in FIG 2F is to lay down the second layer of poly which is the P-doped poly deposition. This layer of poly 76 passes over the oxide layer 58 that covers the collector and steps down over the spacer oxide 60, into the region of the collector epi 34 to contact the underlying base silicon layer 50, passes over the oxide that covers the emitter 70 and again steps down to the underlying silicon base 50 and then passes over the top of the other collector oxide region 58. This region, as it will be a conductive region, is brought out over to one side of the interdigitated collector and terminates over the field oxide 44. It should be noted that the windows in the mask shown in FIG 2F are aligned with and slightly larger than the windows in the mask shown in FIG 2E. This size relationship is used to achieve a stepped via between the first 52, 54, 56 and second 76 layers of poly. Specifically, to define the polysilicon islands and interconnects, the second layer of polysilicon is deposited over the entire surface and implanted with P-dopant (BF₂). The entire surface is then covered with a nitride and a mask is defined which will leave nitride only over the conductive Poly II which will serve as contacts to the base region and to the emitter and collector electrodes, the resistor bodies and to local interconnect. Using the nitride to mask the Poly II, the Poly II outside this nitride is removed (without overetch).

The area outside the nitride is then oxidized, converting any remaining P-doped poly to insulating oxide while forming an insulating oxide cap along the Poly II edge.

The masking step shown in FIG 2G will provide for the formation of the base collector and emitter contact 90, 92, 94 down to the appropriate layers of poly. The connections between the P-doped poly layer 76 and the active base region 50 will be provided by heat treating the doped poly layer which will cause the P-type doping material in the poly to diffuse into the underlying substrate 34, creating the extrinsic base regions 86, 88 which provide contact between this P-type poly material and the active intrinsic base 50. It is possible to add an extra step to this process to form a poly resistor simply by masking the P-poly layer prior to the silicide step which must follow the depositing of the P-poly layer. Without this masking step all of the P-poly is silicided. With the masking step, where the silicide is not formed, a resistor can be defined to be in series with one of the contacts as shown in FIG 21. That is, the doped Poly II is a conductor but it has a much higher resistance (approximately 500 ohms per square) than regions of Poly II covered with the silicide (approximately 1-2 ohms per square). By carefully controlling the length and sheet resistivity and cross-sectional area of the doped regions, the process defines resistors 96 by leaving nitride over the active resistors (with the resistor mask), while siliciding 97 the remaining Poly II 98 outside the resistor mask (FIG 21).

Thereafter, as shown in FIG 2G, glass layer 91 is placed over the whole structure, and windows are cut down where contacts 90, 92, 94 are to be placed.

It is readily apparent to one who views the finished cross section that appears in FIG 2G that very thin layers 34 and 32 are needed to provide the thin epi layer and the buried layer of the present device. Because an interdigitated collector having a dual collector region 72, 74 as provided, the up/down resistance between the collectors and the underlying buried layer 32 is reduced both by the presence of the thin layer 34 and the balanced collector resistance from the emitter to each of the two collectors. Since the collector is in the same active region as the emitter, it can be physically located approximately one-half the distance from the emitter as compared with the prior art device of FIG 1. With two collectors located one-half the distance from the emitter, the collector resistance can be reduced by about 1/4, the buried layer can be much thinner (about 1/4), and the isolation trenches 1/2 to 1/3 as deep as those of the prior art and still maintain a similar value of collector resistance. This reduces production time and costs, improves control, allows shallower structures with less parasitic collector-substrate capacitance (40%), and hence, higher speed performance. Similarly, if a lower collector resistance is a goal of the process, this can be reduced by about 1/4 for the same process.

Putting down the N-poly of the collector and emitter permits integrating the emitter and collector into the same isolation structure. By forming the emitter and collector in the same process step and structure, with base element and contact located within a photolithographically defined space between those collector and emitter elements (separated by an oxide spacer of about 0.25 µm (microns) the concern for mask alignment in subsequent steps is eliminated, thus allowing formation of a double collector that is approximately half the distance from the emitter and which has an overall collector-to-substrate area that is 40% smaller when compared with the prior art.

It is also readily apparent from the description above how spacers 60, 62, 64, 66 are provided between the base region 50 and the collector region 72, 74 so that although the distance from collector to base may be very small on the order of 3/10 µm (micron) the capacitance is very low and the breakdown voltage can still be maintained at relatively high values.

An additional advantage of this structure is that the active area under the emitter is never subjected to etch (RIE) and therefore has potentially fewer defects; hence, higher yields. Prior art devices and processes put down the Poly I as a P-doped base first (P-poly first process) and opens the space between the P-poly stripe for the emitter. This reactive ion etch (RIE) exposure subjects the underlying monocrystalline silicon in the space between base regions to the etch and resulting in potential emitter damage. The present N-poly first process lays down the active emitter first and never subjects the silicon under the shallow and sensitive emitter area to either poly etch (a silicon etch) or to the RIE spacer etch (an oxide etch).

## Claims

1. A method for fabricating a bipolar transistor without a field oxide layer within the epitaxial layer separating the collector contact (54, 56) and base region (50) comprising the following successive steps:
(a) forming on a semiconductor substrate (30) of P-type material a layer (32) of N-type material, over which layer (32) is formed an epitaxial layer (34) of N-type material, whereby said layer (32) is buried;
(b) forming an isolation trench (36, 38) and an adjoining, N-type sinker region (39) in the structure resulting from step (a), in which the isolation trench (36, 38) extends through the epitaxial layer (34), the buried layer (32), and into said substrate (30), and the sinker region (39) provides a low resistance current path from an upper surface of said epitaxial layer (34) to said buried layer (32), the region bounded by said trench (36, 38) defining an isolated region in which the bipolar transistor is to be fabricated;
(c) forming an oxide layer (40, 42) edging the walls of said trench (36, 38) formed in step (b);
(d) filling said trench (36, 38) with polysilicon (36, 38);
(e) forming a field oxide layer (44) over said trench (36, 38);
(f) forming a P-type active base region (50) in said epitaxial layer (34) within said isolated region;
(g) forming an emitter contact (52), and a collector contact (54, 56) on the structure resulting from step (f), comprising the steps of:
(i) forming on the entire epitaxial layer (34) a layer (52, 54, 56) of polysilicon doped with N-type dopant, and forming a protective oxide layer (58) over said polysilicon layer (52, 54, 56);
(ii) patterning said N-type polysilicon layer (52, 54, 56) and said oxide layer (58), said patterning defining an emitter region within said active base region (50) and an emitter contact (52), said emitter contact (52) overlying at least a portion of said active base region (50), and defining a separate collector contact (54, 56) outside said active base region (50), on said epitaxial layer (34), overlying at least a portion of said sinker region (39), said patterning forming vertical sidewalls in said doped polysilicon layer (52, 54, 56) and said oxide layer (58);
(h) depositing an oxide layer over the structure resulting from step (g) and performing an anisotropic etch on this oxide layer, thereby forming oxide sidewall spacers (60, 62, 64, 66, 68) on said isolated region, adjoining said vertical sidewalls in said doped polysilicon layer (52, 54, 56) whereby a portion of said isolated region is left exposed;
(i) heating the structure resulting from step (h) thereby forming an emitter region (70) and a collector contact region (72, 74) by diffusion of said N-type dopant from said polysilicon (52, 54, 56) into said epitaxial layer (34) thereby forming an emitter region (70) having a depth, and thereby forming a collector contact region (72, 74);
(j) depositing a further layer (76) of polysilicon doped with P-type dopant over said oxide layer (58) and in contact with said exposed portion of said isolated region;
(k) heating the structure resulting from step (j) to diffuse said P-type dopant from said further layer of polysilicon (76) into said portion of said isolated region exposed during anisotropic etching in step (h), thereby forming an extrinsic base region (86, 88) adjacent said active base region (50);
whereby said sidewall spacers (60, 62, 64, 66, 68) have a lateral dimension that defines a lateral separation of said collector contact region (72) and said extrinsic base region (86, 88) of said bipolar transistor and said sidewall spacers (60, 62, 64, 66, 68) and said oxide layer (58) providing electrical insulation between said layer (52, 54, 56) of polysilicon doped with said N-type dopant and said further layer of polysilicon (76) doped with said P-type dopant.

2. The method of Claim 1, wherein the depth of said extrinsic base (86, 88) is less than that of said active base region (50).

3. The method of any one of Claims 1 or 2, wherein step (j) includes forming a layer of silicide on at least a portion of said further layer of polysilicon (76), whereby ohmic resistance thereon is reduced.

4. The method of Claim 3, including the further step of masking a portion of said further layer of polysilicon (76) prior to the step of forming a layer of silicide thereon, thereby preventing forming said layer of silicide thereon, said portion so masked defining a resistor.

5. The method of any preceding claim, wherein said buried layer (32) has a thickness of about 1 µm, and said epitaxial layer (34) has a thickness of about 0.75 µm.

6. The method of any preceding claim, wherein step (b) includes the steps of:
(i) etching a preliminary trench (36, 38) extending down into said buried layer (32) but not into said substrate (30);
(ii) diffusing said preliminary trench (36, 38) with said N-type dopant thereby forming said N-type sinker region (39), said N-type sinker region (39) extending into said buried layer (32) and into said epitaxial layer adjacent said trench (36, 38);
(iii) etching said preliminary trench (36, 38) through a bottom thereof into said substrate (30) thereby forming said trench (36, 38); and
(iv) edging said trench (36, 38) with oxide and filling said trench (36, 38) with a deposition of polysilicon that is then planarized.

7. The method of any preceding claim, wherein step (b) includes the preliminary step of forming a mask through which said active base region (50) is implanted with boron.

8. The method of any preceding claim, wherein said bipolar transistor includes two collector contacts (54, 56), and wherein step (b) includes forming a said N-type sinker region (39) for each of said collector contacts (54, 56).

9. The method of any preceding claim, wherein at step (g) said emitter and collector contacts (52, 54, 56) are simultaneously formed on said isolated region.

10. The method of any preceding claim, wherein at step (g) (i), said polysilicon layer (52, 54, 56) is doped as it is formed or after it is formed.

11. The method of any preceding claim, wherein step (g) includes the step of forming a silicide layer (57, 59) overlying the layer of N-type polysilicon (52, 54, 56) formed in step (g) (i), and wherein step (g) (ii) includes the step of patterning said layer of silicide (57, 59), said layer of N-type polysilicon (52, 54, 56), and said oxide layer (58) thereby defining said emitter region and said emitter contact (52), and defining said separate collector contact (54, 56), wherein said step of patterning forms vertical sidewalls in said silicide layer (57, 59), in said doped polysilicon layer (52, 54, 56), and in said oxide layer (58).

12. The method of any preceding claim, wherein at step (h), said sidewall spacers (60, 62, 64, 66, 68) have a lateral dimension of about 0.25 µm.

## Patentansprüche

1. Verfahren zur Herstellung eines Bipolartransistors ohne Feldoxidschicht in der den Kollektorkontakt (54, 56) und den Basisbereich (50) trennenden Epitaxialschicht mit den folgenden aufeinanderfolgenden Schritten:
(a) Bilden einer Schicht (32) aus N-Typ-Material auf einem Halbleitersubstrat (30) aus P-Typ-Material, wobei über der Schicht (32) eine Epitaxialschicht (34) aus N-Typ-Material gebildet wird, durch die die Schicht (32) abgedeckt wird;
(b) Bilden eines Isolationsgrabens (36, 38) und eines anliegenden N-Typ-Sinkerbereichs (39) in der aus Schritt (a) resultierenden Struktur, wobei sich der Isolationsgraben (36, 38) durch die Epitaxialschicht (34), die abgedeckte Schicht (32) und in das Substrat (30) hinein erstreckt und der Sinkerbereich (39) einen Niederwiderstandsstrompfad von einer oberen Oberfläche der Epitaxialschicht (34) zur abgedeckten Schicht (32) bildet, wobei der von dem Graben (36, 38) eingefaßte Bereich einen isolierten Bereich bildet, in dem der Bipolartransistor hergestellt wird;
(c) Bilden einer Oxidschicht (40, 42), die die Wände des in Schritt (b) gebildeten Grabens (36, 38) auskleidet;
(d) Füllen des Grabens (36, 38) mit polykristallinem Silizium (36, 38);
(e) Bilden einer Feldoxidschicht (44) über dem Graben (36, 38);
(f) Bilden eines aktiven P-Typ-Basisbereichs (50) in der Epitaxialschicht (34) im isolierten Bereich;
(g) Bilden eines Emitterkontakts (52) und eines Kollektorkontakts (54, 56) auf der aus Schritt (f) resultierenden Struktur, mit den folgenden Schritten:
(i) Bilden einer Schicht (52, 54, 56) aus N-dotiertem polykristallinem Silizium auf der gesamten Epitaxialschicht (34) und Bilden einer schützenden Oxidschicht (58) über der Schicht (52, 54, 56) aus polykristallinem Silizium;
(ii) Mustern der N-Typ-Schicht aus polykristallinem Silizium (52, 54, 56) und der Oxidschicht (58), wobei das Muster einen Emitterbereich im aktiven Basisbereich (50) und einen Emitterkontakt (52) definiert, wobei der Emitterkontakt (52) mindestens einen Teil des aktiven Basisbereichs (50) bedeckt, und einen getrennten Kollektorkontakt (54, 56) außerhalb des aktiven Basisbereichs (50) auf der Epitaxialschicht (34) definiert, der mindestens einen Teil des Sinkerbereichs (39) bedeckt, wobei durch das Mustern senkrechte Seitenwände in der Schicht aus dotiertem polykristallinem Silizium (52, 54, 56) und der Oxidschicht (58) entstehen;
(h) Abscheiden einer Oxidschicht auf der aus Schritt (g) resultierenden Struktur und Durchführen einer anisotropen Ätzung an der Oxidschicht, wodurch Oxid-Seitenwand-Abstandsstücke (60, 62, 64, 66, 68) auf dem an die senkrechten Seitenwände der dotierten Schicht (52, 54, 56) aus polykristallinem Silizium anschließenden isolierten Bereich gebildet werden, wodurch ein Teil des isolierten Bereichs unabgedeckt bleibt;
(i) Erwärmen der aus Schritt (h) resultierenden Struktur, wodurch ein Emitterbereich (70) und ein Kollektorkontaktbereich (72, 74) durch eine Diffusion der N-Dotiersubstanz vom polykristallinen Silizium (52, 54, 56) in die Epitaxialschicht (34) gebildet wird, wodurch ein Emitterbereich (70) mit einer Tiefe und dadurch ein Kollektorkontaktbereich (72, 74) entsteht;
(j) Abscheiden einer weiteren Schicht (76) aus P-dotiertem polykristallinem Silizium auf der Oxidschicht (58) und in Kontakt mit dem freiliegenden Teil des isolierten Bereichs;
(k) Erwärmen der aus Schritt (j) resultierenden Struktur zum Diffundieren der P-Dotiersubstanz aus der weiteren Schicht (76) aus polykristallinem Silizium in den Teil des isolierten Bereichs, der während des anisotropen Ätzens in Schritt (h) freilag, wodurch ein extrinsischer Basisbereich (86, 88) neben dem aktiven Basisbereich (50) gebildet wird;
wobei die Seitenwand-Abstandsstücke (60, 62, 64, 66, 68) eine seitliche Ausdehnung haben, die eine seitliche Trennung des Kollektorkontaktbereichs (72) und des extrinsischen Basisbereichs (86, 88) des Bipolartransistors definieren und die Seitenwand-Abstandsstücke (60, 62, 64, 66, 68) und die Oxidschicht (58) eine elektrische Isolation zwischen der Schicht (52, 54, 56) aus N-dotierten polykristalliniem Silizium und der weiteren Schicht (76) aus P-dotiertem polykristallinem Silizium herstellen.

2. Verfahren nach Anspruch 1, bei dem die Tiefe der extrinsischen Basis (86, 88) geringer ist als diejenige des aktiven Basisbereichs (50).

3. Verfahren nach einem der Ansprüche 1 oder 2, bei dem der Schritt (j) beinhaltet, daß eine Silizidschicht auf mindestens einem Teil der weiteren Schicht aus polykristallinem Silizium (76) gebildet wird, wodurch deren ohmscher Widerstand verringert wird.

4. Verfahren nach Anspruch 3, mit dem folgenden weiteren Schritt: Maskieren eines Teils der weiteren Schicht aus polykristallinem Silizium (76) vor dem Schritt des Bildens einer Silizidschicht darauf, wodurch das Bilden der Silizidschicht darauf verhindert wird, wobei der derart maskierte Bereich einen Widerstand definiert.

5. Verfahren nach einem der vorhergehenden Ansprüche, bei dem die abgedeckte Schicht (32) eine Dicke von ungefähr 1 µm hat und die Epitaxialschicht (34) eine Dicke von ungefähr 0,75 µm hat.

6. Verfahren nach einem der vorhergehenden Ansprüche, bei dem der Schritt (b) die folgenden Schritte aufweist:
(i) Ätzen eines vorläufigen Grabens (36, 38), der sich in die abgedeckte Schicht (32), jedoch nicht in das Substrat (30) erstreckt;
(ii) Diffundieren des vorläufigen Grabens (36, 38) mit N-Dotiersubstanz, wodurch der N-Typ-Sinkerbereich (39) gebildet wird, wobei sich der N-Typ-Sinkerbereich (39) in die abgedeckte Schicht (32) und in die an den Graben (36, 38) anliegende Epitaxialschicht hinein erstreckt;
(iii) Ätzen des vorläufigen Grabens (36, 38) durch einen Boden davon in das Substrat (30), wodurch der Graben (36, 38) gebildet wird; und
(iv) Auskleiden des Grabens (36, 38) mit Oxid und Füllen des Grabens (36, 38) mit einer Abscheidung aus polykristallinem Silizium, die dann planarisiert wird.

7. Verfahren nach einem der vorhergehenden Ansprüche, bei dem Schritt (b) den vorangehenden Schritt des Bildens einer Maske beinhaltet, durch die der Basisbereich (50) mit Bor implantiert wird.

8. Verfahren nach einem der vorhergehenden Ansprüche, bei dem der Bipolartransistor zwei Kollektorkontakte (54, 56) aufweist und bei dem Schritt (b) beihaltet, daß ein N-Typ-Sinkerbereich (39) für jeden der Kollektorkontakte (54, 56) gebildet wird.

9. Verfahren nach einem der vorhergehenden Ansprüche, bei dem beim Schritt (g) der Emitter- und die Kollektorkontakte (52, 54, 56) gleichzeitig auf dem isolierten Bereich gebildet werden.

10. Verfahren nach einem der vorhergehenden Ansprüche, bei dem beim Schritt (g) (i) die Schicht (52, 54, 56) aus polykristallinem Silizium dotiert wird, während sie gebildet wird oder nachdem sie gebildet wird.

11. Verfahren nach einem der vorhergehenden Ansprüche, bei dem der Schritt (g) den Schritt des Bildens einer Silizidschicht (57, 59) über der in Schritt (g) (i) gebildeten Schicht aus polykristallinem N-Typ-Silizium (52, 54, 56) beinhaltet und bei dem der Schritt (g) (ii) den Schritt des Musterns der Silizidschicht (57, 59), der Schicht aus polykristallinem N-Typ-Silizium (52, 54, 56) und der Oxidschicht (58) beinhaltet, wodurch der Emitterbereich und der Emitterkontakt (52) sowie der getrennte Kollektorkontakt (54, 56) definiert werden, wobei durch den Schritt des Musterns senkrechte Seitenwände in der Silizidschicht (57, 59), in der dotierten polykristallinen Siliziumschicht (52, 54, 56) und in der Oxidschicht (58) entstehen.

12. Verfahren nach einem der vorhergehenden Ansprüche, bei dem beim Schritt (h) die Seitenwand-Abstandsstücke (60, 62, 64, 66, 68) eine seitliche Ausdehnung von ungefähr 0,25 µm haben.

## Revendications

1. Procédé de fabrication d'un transistor bipolaire sans couche d'oxyde de champ dans la couche épitaxiale séparant le contact (54, 56) de collecteur et une région de base (50), comprenant les étapes successives suivantes dans lesquelles :
(a) on forme, sur un substrat semiconducteur (30) de matière de type P, une couche (32) de matière de type N, couche (32) sur laquelle une couche épitaxiale (34) de matière de type N est formée, grâce à quoi ladite couche (32) est enterrée ;
(b) on forme une tranchée d'isolation (36, 38) et une région (39) de réception de type N, contiguë, dans la structure résultant de l'étape (a), la tranchée (36, 38) d'isolation s'étendant à travers la couche épitaxiale (34), la couche enterrée (32) et jusque dans ledit substrat (30), et la région de réception (39) établissant un trajet de courant à faible résistance depuis une surface supérieure de ladite couche épitaxiale (34) jusqu'à ladite couche enterrée (32), la région délimitée par ladite tranchée (36, 38) définissant une région isolée dans laquelle le transistor bipolaire doit être fabriqué ;
(c) on forme une couche d'oxyde (40, 42) bordant les parois de ladite tranchée (36, 38) formée dans l'étape (b) ;
(d) on remplit ladite tranchée (36, 38) de polysilicium (36, 38) ;
(e) on forme une couche (44) d'oxyde de champ sur ladite tranchée (36, 38) ;
(f) on forme une région de base active (50) de type P dans ladite couche épitaxiale (34) à l'intérieur de ladite région isolée ;
(g) on forme un contact d'émetteur (52), et un contact de collecteur (54, 56) sur la structure résultant de l'étape (f), comprenant les étapes de :
(i) formation sur toute la couche épitaxiale (34) d'une couche (52, 54, 56) de polysilicium dopé avec un dopant de type N, et formation d'une couche protectrice d'oxyde (58) sur ladite couche de polysilicium (52, 54, 56) ;
(ii) formation d'un motif de ladite couche (52, 54, 56) de polysilicium de type N et de ladite couche (58) d'oxyde, ladite formation de motif définissant une région d'émetteur à l'intérieur de ladite région de base active (50) et un contact d'émetteur (52), ledit contact d'émetteur (52) s'étendant au-dessus d'au moins une partie de ladite région de base active (50), et définissant un contact de collecteur séparé (54, 56) à l'extérieur de ladite région de base active (50), sur ladite couche épitaxiale (34), s'étendant sur au moins une partie de ladite région de réception (39), ladite formation de motif formant des parois latérales verticales dans ladite couche (52, 54, 56) de polysilicium dopé et dans ladite couche (58) d'oxyde ;
(h) à déposer une couche d'oxyde sur la structure résultant de l'étape (g) et réaliser une attaque anisotrope sur cette couche d'oxyde, formant ainsi des pièces d'écartement (60, 62, 64, 66, 68) de parois latérales en oxyde sur ladite région isolée, contiguës auxdites parois latérales verticales dans ladite couche (52, 54, 56) de polysilicium dopé, grâce à quoi une partie de ladite région isolée reste à découvert ;
(i) à chauffer la structure résultant de l'étape (h) pour former ainsi une région d'émetteur (70) et une région (72, 74) de contact de collecteur par diffusion dudit dopant de type N depuis ledit polysilicium (52, 54, 56) jusque dans ladite couche épitaxiale (34) de façon à former une région d'émetteur (70) ayant une profondeur, et à former ainsi une région (72, 74) de contact de collecteur ;
(j) à déposer une autre couche (76) de polysilicium dopé avec un dopant du type P sur ladite couche d'oxyde (58) et en contact avec ladite partie à découvert de ladite région isolée ;
(k) à chauffer la structure résultant de l'étape (j) pour diffuser ledit dopant de type P depuis ladite autre couche de polysilicium (76) jusque dans ladite partie de ladite région isolée mise à découvert pendant ladite attaque anisotrope dans l'étape (h), formant ainsi une région de base extrinsèque (86, 88) adjacente à ladite région de base active (50) ;
grâce à quoi lesdites pièces d'écartement (60, 62, 64, 66, 68) de parois latérales ont une dimension latérale qui définit une séparation latérale de ladite région (72) de contact de collecteur et de ladite région de base extrinsèque (86, 88) dudit transistor bipolaire et lesdites pièces d'écartement (60, 62, 64, 66, 68) de parois latérales et ladite couche d'oxyde (58) établissant une isolation électrique entre ladite couche (52, 54, 56) de polysilicium dopé avec ledit dopant de type N et ladite autre couche de polysilicium (76) dopé avec ledit dopant de type P.

2. Procédé selon la revendication 1, dans lequel la profondeur de ladite base extrinsèque (86, 88) est inférieure à celle de ladite région de base active (50).

3. Procédé selon l'une quelconque des revendications 1 ou 2, dans lequel l'étape (j) comprend la formation d'une couche de siliciure sur au moins une partie de ladite autre couche de polysilicium (76), grâce à quoi la résistance ohmique sur celui-ci est réduite.

4. Procédé selon la revendication 3, comprenant en outre l'étape de masquage d'une partie de ladite autre couche de polysilicium (76) avant l'étape de formation d'une couche de siliciure sur celui-ci, empêchant ainsi la formation de ladite couche de siliciure sur celui-ci, ladite partie ainsi masquée définissant une résistance.

5. Procédé selon l'une quelconque des revendications précédentes, dans lequel ladite couche enterrée (32) présente une épaisseur d'environ 1 µm, et ladite couche épitaxiale (34) présente une épaisseur d'environ 0,75 µm.

6. Procédé selon l'une quelconque des revendications précédentes, dans lequel l'étape (b) comprend les étapes dans lesquelles :
(i) on forme par attaque une tranchée préliminaire (36, 38) descendant jusqu'à dans ladite couche enterrée (32), mais non jusque dans ledit substrat (30) ;
(ii) on diffuse ledit dopant de type N dans ladite tranchée préliminaire (36, 38) afin de former ladite région de réception (39) du type N, ladite région de réception (39) de type N s'étendant jusque dans ladite couche enterrée (32) et jusque dans ladite couche épitaxiale adjacente à ladite tranchée (36, 38) ;
(iii) on attaque le fond de ladite tranchée préliminaire (36, 38) jusque dans ledit substrat (30) afin de former ladite tranchée (36, 38) ; et
(iv) on borde ladite tranchée (36, 38) d'oxyde et on remplit ladite tranchée (36, 38) par un dépôt de polysilicium qui est ensuite aplani.

7. Procédé selon l'une quelconque des revendications précédentes, dans lequel l'étape (b) comprend l'étape préliminaire de formation d'un masque à travers lequel du bore est implanté dans ladite région de base active (50).

8. Procédé selon l'une quelconque des revendications précédentes, dans lequel ledit transistor bipolaire comprend deux contacts de collecteur (54, 56), et dans lequel l'étape (b) comprend la formation de ladite région (39) de réception de type N pour chacun desdits contacts de collecteur (54, 56).

9. Procédé selon l'une quelconque des revendications précédentes, dans lequel, à l'étape (g), lesdits contacts d'émetteur et de collecteur (52, 54, 56) sont formés simultanément sur ladite région isolée.

10. Procédé selon l'une quelconque des revendications précédentes, dans lequel, à l'étape (g) (i), ladite couche de polysilicium (52, 54, 56) est dopée pendant ou après sa formation.

11. Procédé selon l'une quelconque des revendications précédentes, dans lequel l'étape (g) comprend l'étape de formation d'une couche de silicium (57, 59) s'étendant au-dessus de la couche de polysilicium (52, 54, 56) de type N formée dans ladite étape (g) (i), et dans lequel l'étape (g) (ii) comprend l'étape de formation d'un motif dans ladite couche de siliciure (57, 59), dans ladite couche de polysilicium de type N (52, 54, 56) et dans ladite couche d'oxyde (58) afin de définir ladite région d'émetteur et ledit contact d'émetteur (52), et de définir ledit contact de collecteur séparé (54, 56), ladite étape de formation de motif formant lesdites parois latérales verticales dans ladite couche de siliciure (57, 59), dans ladite couche (52, 54, 56) de polysilicium dopé et dans ladite couche d'oxyde (58).

12. Procédé selon l'une quelconque des revendications précédentes, dans lequel, à l'étape (h), lesdites pièces d'écartement (60, 62, 64, 66, 68) de parois latérales ont une dimension latérale d'environ 0,25 µm.
